# EUROPÄISCHE PATENTSCHRIFT

(11) **EP 3 479 237 B1**
(45) Veröffentlichungstag und Bekanntmachung des Hinweises auf die Patenterteilung: **06.07.2022**
(21) Anmeldenummer: 17733359.8
(22) Anmeldetag: 30.05.2017
(51) Int. Cl.: G01R 31/3193, G06F 9/52, H03L 7/07, G01R 31/319

(54) **VERFAHREN ZUR SYNCHRONISATION EINER ÜBERPRÜFUNGSVORRICHTUNG SOWIE EINE ÜBERPRÜFUNGSVORRICHTUNG UND EIN ZUMINDEST ZWEI ÜBERPRÜFUNGSVORRICHTUNGEN UMFASSENDES VERBUNDSYSTEM**
METHOD FOR SYNCHRONIZING AN INSPECTION DEVICE AND AN INSPECTION DEVICE AND A COMPOSITE SYSTEM COMPRISING AT LEAST TWO INSPECTION DEVICES
PROCÉDÉ DE SYNCHRONISATION D'UN DISPOSITIF DE CONTRÔLE AINSI QUE DISPOSITIF DE CONTRÔLE ET SYSTÈME INTERCONNECTÉ COMPORTANT AU MOINS DEUX DISPOSITIFS DE CONTRÔLE

(30) Priorität: 01.07.2016 DE 102016007966
(43) Veröffentlichungstag der Anmeldung: 08.05.2019
(73) Patentinhaber: dSPACE GmbH, 33102 Paderborn (DE)
(72) Erfinder: KLEMM, Matthias, 33106 Paderborn (DE); BALDIN, Daniel, 59320 Ennigerloch (DE)
(86) Internationale Anmeldenummer: PCT/EP2017/062970
(87) Internationale Veröffentlichungsnummer: WO 2018/001667

(56) Entgegenhaltungen:
- EP-A2- 1 638 243
- WO-A1-96/03679
- DE-C2- 19 906 866
- US-A1- 2006 067 449
- US-A1- 2008 240 321
- US-A1- 2014 071 982
- US-B1- 6 633 621

## Beschreibung

Die Erfindung betrifft einerseits ein Verfahren zur Synchronisation einer Überprüfungsvorrichtung, wobei die Überprüfungsvorrichtung zum Testen mindestens eines ersten elektronischen Regelungsgerätes eingerichtet ist und andererseits eine Überprüfungsvorrichtung, die mittels des erfindungsgemäßen Verfahrens in einen synchronisierten Zustand überführbar ist. Verbundsystem umfassend zumindest zwei Überprüfungsvorrichtungen.

Die Erfindung betrifft außerdem eine Überprüfungsvorrichtung zum Testen mindestens eines ersten Regelungsgerätes, und schließlich betrifft die Erfindung ein Verbundsystem umfassend zumindest eine Überprüfungsvorrichtung und eine weitere Überprüfungsvorrichtung, wobei die letztere gleichwirkend zu der erstgenannten Überprüfungsvorrichtung ausgestaltet ist.

Häufig umfassen Überprüfungsvorrichtungen zumindest eine erste Recheneinheit und eine räumlich von der ersten Recheneinheit getrennte zweite Recheneinheit, wobei die erste Recheneinheit einen ersten ausführbaren Modellcode zur Berechnung eines ersten Teilmodells des Regelstreckenmodells aufweist und die zweite Recheneinheit einen zweiten ausführbaren Modellcode zur Berechnung eines zweiten Teilmodells des Regelstreckenmodells aufweist.

Aus einem veröffentlichten Produktkatalog "Catalog 2015 / Embedded Success dSPACE", der als gedruckter Katalog erhältlich ist, im weiteren Text unter Angabe der Referenznummer "P1" zitiert wird, und im Internet zu finden ist unter www.dspace.com/de/gmb/home/medien/product_info/catalog_contents.cfm sind Vorrichtungen zum Testen von Regelungsgeräten bekannt. Insbesondere in P1 auf den Seiten 296 bis 331 sowie auf den Seiten 496 bis 515 werden Vorrichtungen und deren Bestandteile für den genannten Anwendungszweck beschrieben. Die Vernetzung der Vorrichtungen ist beispielsweise mittels Ethernet-Schnittstellenkarten, wie bspw. in o.g. Produktkatalog auf den Seiten 472 und 473 realisierbar. Derartige Vorrichtungen können als sogenannte "HIL-Simulatoren" ausgestaltet sein, wobei die Abkürzung "HIL" (engl.: "hardware in the loop") auf einen geschlossenen Regelkreis hinweist.

Die eingangs genannten Regelungsgeräte werden oft als Steuergerät bezeichnet, obwohl deren Funktionsumfang im systemtheoretischen Sinne meist über die "reine" Steuerungsfunktion hinausgeht und Regelungsfunktionen umfasst.

Die erste Recheneinheit der Überprüfungsvorrichtung, die zumindest einen ersten Mikroprozessor aufweist, ist vorgesehen und eingerichtet, um einen ersten Modellcode, der zumindest einen Teil der Regelstreckensimulation realisiert, mittels des Mikroprozessors auszuführen.

Der Modellcode bildet zusammen mit der Hardware der Überprüfungsvorrichtung die technische Umgebung eines elektronischen Gerätes oder eines komplexeren technischen Systems zumindest teilweise nach. Mittels des Modellcodes stellt die Überprüfungsvorrichtung beispielsweise simulierte Sensorsignale für das Regelungsgerät bereit. Des Weiteren kann die Überprüfungsvorrichtung beispielsweise als eine gesteuerte Stromsenke für die Ableitung eines von dem Regelungsgerät bereitgestellten Aktor-Stroms dienen.

Die sogenannte HIL-Simulation ist ein internationaler, insbesondere auch im deutschen Sprachraum verwendeter, Fachbegriff für eine Testmethode, bei der ein "eingebettetes System", beispielsweise ein Regelungsgerät oder ein mechatronisches Modul über seine Eingänge und Ausgänge an ein angepasstes Gegenstück, beispielsweise eine als HIL-Simulator ausbildete Überprüfungsvorrichtung, die zur Nachbildung der realen Umgebung des eingebetteten Systems dient, angeschlossen ist. Während des Tests des eingebetteten Systems werden also zumindest ein Teil der Eingangssignale für das eingebettete System von dem HIL-Simulator bereitgestellt und zumindest ein Teil der Ausgangssignale des eingebetteten Systems an den HIL-Simulator gesendet.

Beispielsweise kann mittels eines Modellcodes eines Regelstreckenmodells, der auf einem HIL-Simulator ausgeführt wird, das zeitliche Verhalten der Umgebung des zu testenden Systems nachgebildet werden. Soll z.B. ein HIL-Simulator ein eingebettetes System, insbesondere ein Regelungsgerät (oft als ECU abgekürzt, engl.: "electronic control unit), testen, dann ist der HIL-Simulator als zumindest teilweise Nachbildung der realen Umgebung des Regelungsgerätes ausgestaltet. Der HIL-Simulator kann also in diesem Fall über seine die Ein- und Ausgänge bzw. bidirektionale Kommunikationskanäle mit dem Steuergerät kommunizieren und somit als angepasstes Gegenstück des Regelungsgerätes fungieren.

Die HIL-Simulation muss meist in Echtzeit ablaufen. Bei der Simulation der technischrelevanten Umgebung des Regelungsgerätes, wobei die simulierte Umgebung die die simulierte Regelstrecke umfasst, können insbesondere solche Interaktionen des Regelungsgerätes, die in einer späteren realen Umgebung des Regelungsgerätes wiederkehren können, automatisiert und/oder in vordefinierter Reihenfolge nachgebildet werden. Dies hat den Vorteil, dass eine neue Entwicklungsversion einer Steuerungs- oder Regelungssoftware unter den gleichen Kriterien getestet werden kann, wie die Vorgängerversion. Somit kann detailliert nachgewiesen werden, ob ein Fehler beseitigt wurde oder nicht (Fehlernachtest, engl. re-testing).

Die Tests an realen Systemen (bspw. an einem Bremssystem oder einem Antischlupfsystem eines Kraftfahrtzeugs) lassen sich mittels der Tests am HIL-Simulator stark verringern und zusätzlich lassen sich Systemgrenzen bzw. Grenzen der Beherrschbarkeit des Regelungsgeräts und/oder der Regelstrecke ermitteln, ohne das reale System und dessen Nutzer (z. B. Automobil und Fahrer) zu gefährden.

Die HIL-Simulation ist immer nur eine Vereinfachung der Realität und kann den später meist folgenden Test am realen System, beispielsweise den Test der Interaktion des Regelungsgerätes mit der "echten" Regelstrecke eines geregelten Prototypen und/oder den Test der Interaktion des Regelungsgerätes mit einem geregelten Serienprodukt, üblicherweise nicht vollständig ersetzen.

Es ist bekannt, eine räumlich verteilte Überprüfungsvorrichtung zum Testen zumindest eines elektronischen Regelungsgerätes zu verwenden, wobei die Überprüfungsvorrichtung zumindest zwei getrennte Recheneinheiten - beispielsweise zumindest zwei beabstandete und vernetzte Simulatoren - umfasst. Bereits in dem im Jahr 2002 veröffentlichten - nachfolgend mit P2 referenzierten - Dokument "A Hardware-in-the-Loop Test Bench for the Validation of Complex ECU Networks", J. Gehring, H. Schütte, dSPACE GmbH, Seite 3, Figur 3 des 2002er Dokuments, Veröffentlichungshinweis "SAE 2002 Word Congress Detroit, Michigan March 4-7, 2002", ist eine als verteilter HIL-Simulator ausgestaltete Überprüfungsvorrichtung dargestellt, die mehrere Recheneinheiten aufweist, die hier beispielsweise als Zentraleinheit also "Central Unit", Motoreinheit also "Engine", Kraftübertragungseinheit also "Transmission" und kombinierte ESP-Federungseinheit also "ESP Suspension" ausgestaltet sind. Die Recheneinheiten sind über ein optisches Verbindungsmittel also ein "High-speed optical link" miteinander vernetzt. Auf Seite 7, rechts, Abschnitt "Conclusion", zweiter Aufzählungspunkt desselben Dokuments wird erwähnt, dass Anforderungen für eine Interprozessor-Kommunikation eine Zeitstempelung und eine automatische Prozess-Synchronisierung erfordern können.

Aus dem - nachfolgend mit P3 referenzierten - Dokument "Hardware-in-the-Loop Technology Enabling Flexible Testing Processes", Andreas Himmler, dSPACE GmbH, Seite 3, Absatz B., Veröffentlichungshinweis "51 st AIAA Aerospace Sciences Meeting, 2013, Grapevine, TX, USA" ist bekannt, für HIL-Simulatoren ein auf der physikalischen Schicht des Gigibit-Ethernet aufbauendes serielles Netzwerk namens IOCNET^{®} bereitzustellen, mit dessen Hilfe die für die Eingabe und Ausgabe von Signalen und Daten vorgesehenen Interface-Karten, abgekürzt als I/O-Karten, sowohl untereinander als auch mit der/den Mikroprozessorkarte/n in Echtzeit Daten austauschen können. Für den Datenaustausch zwischen den beispielsweise bis zu 100 Meter entfernten I/O-Karten und/oder Prozessorkarten können sogenannte Gigalink-Module zum Einsatz kommen, wie sie beispielsweise im o.g. Dokument P1 auf den Seiten 355 und 361 gezeigt werden. Als Datenübertragungsmedien zwischen den beispielsweise 100 Meter entfernten I/O-Karten und/oder Prozessorkarte/n werden in P3, Seite 3, Absatz B und in P1, Seite 349 eine Glasfaserkabelverbindung, hier als "optical media" oder "fiber-optic cable" bezeichnet, vorgeschlagen. Das bereits genannte Netzwerk IOCNET stellt ein Protokoll bereit, das eine Zeitsynchronisation, insbesondere für das Einlesen von Eingangssignalen an den Schnittstellen der verwendeten I/O-Karten unterstützt; siehe ggf. hierzu Dokument P1, Seite 299 zusammen mit der Abbildung auf derselben Seite. EP1638243 und WO9603679 offenbaren jeweils, die Zeitdifferenz zwischen verschiedenen Eingangszeitsignalen mittels PLL und Multiplexer Schaltungen zu ermitteln und auszugleichen.

Die oben genannte Vernetzungs-Lösungen mittels IOCNET^{®} zur Zeitsynchronisierung innerhalb einer Überprüfungsvorrichtung - insbesondere eines HIL-Simulators - zum Testen eines Regelungsgerätes ist allerdings nur vorgesehen für einen Abstand zwischen den Recheneinheiten, der 100 Meter nur unwesentlich überschreitet.

Die Entwicklung von Regelungsgeräten und der darin implementierten Regelungssoftware erfolgt zunehmend in räumlich verteilten Arbeitsgruppen. Hierbei sind häufig mehrere Unternehmen an verschiedenen Standorten beteiligt. Die beteiligten Software- und Hardware-Entwickler benötigen zum Test der Regelungsgeräte in den fortschreitenden Entwicklungsphasen daher häufig angepasste, insbesondere vor Ort anpassbare Überprüfungsvorrichtungen zum Testen.

Es kann somit zukünftig eine Nachfrage nach einer Überprüfungsvorrichtung zum Testen entstehen, die beispielsweise Netzwerk aus zwei oder mehr Recheneinheiten - beispielsweise HIL-Simulatoren - umfasst, wobei sich diese Recheneinheiten bzw. HIL-Simulatoren an unterschiedlichen Standorten befinden, wobei die Standorte einen Abstand von deutlich mehr als 100 Metern aufweisen könnten.

Regelungsgeräte sind in der praktischen Anwendung sehr häufig mit weiteren Regelungsgeräten vernetzt. Beispielsweise sind Kraftfahrzeuge mit mehr als 40 Regelungsgeräten keine Seltenheit, wobei einige der Regelungsgeräte je nach Anwendungsfall nur vernetzt den jeweils zugeordneten Funktionsumfang sicherstellen können, was am Beispiel der Vernetzung eines Automatikgetriebe-Regelungsgerätes mit einem Motor-Regelungsgerät unmittelbar einleuchtend ist.

Sollte ein Bedarf entstehen, Regelungsgeräte an verschiedenen Standorten mit einer verteilten Überprüfungsvorrichtung zum Testen, insbesondere mit einer aus mehreren HIL-Simulatoren bestehenden Überprüfungsvorrichtung, zu verbinden, die beispielsweise mehrere hundert Meter oder mehrere Kilometer voneinander entfernt sind, sich gegebenenfalls sogar auf unterschiedlichen Kontinenten befinden könnten, dann würden bisherige Lösungen einer Vernetzung und Synchronisation der Recheneinheiten der verteilten Überprüfungsvorrichtung unter Umständen - je nach Entfernung der Recheneinheiten der Überprüfungsvorrichtung - versagen, oder es müssten mit den bisherigen Lösungen der Vernetzung und Synchronisation massive Nachteile, insbesondere bezüglich der Genauigkeit der zeitlichen Zuordnung von Interaktionen zwischen den Regelungsgeräten und deren Überprüfungsvorrichtung zum Testen, hingenommen werden.

Ein weiteres Problem bekannter Überprüfungsvorrichtungen ist, das deren elektronische Uhrenschaltungen, meist als "Uhren" abgekürzt, die zur Bereitstellung eines Uhrensignals an weitere Komponenten der Überprüfungsvorrichtung vorgesehen sind, eine Zeitdrift aufweisen.

Vor diesem Hintergrund besteht eine Aufgabe der vorliegenden Erfindung darin,
- ein Verfahren zur Synchronisation einer Überprüfungsvorrichtung anzugeben, das den Stand der Technik weiterbildet;
und besteht eine zweite Aufgabe der vorliegenden Erfindung darin,
- eine Überprüfungsvorrichtung anzugeben, die den Stand der Technik weiterbildet;
und besteht eine dritte Aufgabe der vorliegenden Erfindung darin,
- ein Verbundsystem umfassend zumindest zwei Überprüfungsvorrichtungen anzugeben, das den Stand der Technik weiterbildet.

Hinsichtlich des Verfahrens wird die Aufgabe erfindungsgemäß durch die in dem Anspruch 1 angegebenen Merkmale gelöst,
hinsichtlich der Überprüfungsvorrichtung wird die Aufgabe erfindungsgemäß durch die in dem Anspruch 7 angegebenen Merkmale gelöst,
hinsichtlich des Verbundsystems wird die Aufgabe erfindungsgemäß durch die in dem Anspruch 10 angegebenen Merkmale gelöst.

Vorteilhafte Ausgestaltungen der Erfindung sind Gegenstand von abhängigen Patentansprüchen.

Ein Vorteil der Erfindung besteht darin, dass eingangs genannte Probleme des Standes der Technik zumindest teilweise ausgeräumt werden.

Erfindungsgemäß wird ein Verfahren zur Synchronisation einer Überprüfungsvorrichtung 10 vorgeschlagen, wobei die Überprüfungsvorrichtung 10 zum Testen mindestens eines ersten Regelungsgerätes eingerichtet ist und die Überprüfungsvorrichtung 10 zumindest umfasst: eine erste Recheneinheit Cn1 zur Ausführung eines Modellcodes, wobei mittels des Modellcodes ein simuliertes Regelstreckensignal zur Stimulierung des Regelungsgerätes bereitstellbar ist und ein Aktorsignal des Regelungsgerätes bearbeitbar ist, und eine erste Zeitsignalwandlereinheit 300 aufweisend zumindest
(i) eine erste Zeitsignalschnittstelle G1 zur Aufnahme eines ersten Zeitsignals Ts1 einer globalen Zeitsignalquelle, die einer globalen Zeit-Skala zugeordnet ist, und
(ii) eine erste Umschaltsignalsendeeinheit 310, die eingerichtet ist, um ein erstes Umschaltsignal Tr1 zur Weitergabe an einen ersten Multiplexer 164 bereitzustellen, und
(iii) eine erste Taktsendeeinheit 312, die eingerichtet ist, um aus dem ersten Zeitsignal Ts1 ein erstes periodisches Taktsignal Tp1 zu erzeugen und das erste periodische Taktsignal Tp1 an eine erste PLL 191 auszugeben, und wobei die Überprüfungseinrichtung 10 des Weiteren umfasst:
   (a) einen ersten Oszillator 161, der eingerichtet ist, um ein zweites periodisches Taktsignals Tp2 zu erzeugen und das zweite periodische Taktsignal Tp2 an eine zweite PLL 192 auszugeben, und
   (b) eine erste Uhr 166, die einerseits mittels einer ersten Taktsignalleitung 168 mit dem ersten Multiplexer 164 verbunden ist und andererseits eingerichtet ist, um ein erstes Uhrensignal Tc1, das auf eine erste lokale Zeit-Skala CL1 bezogen ist, an eine erste Eingabe-Ausgabe-Einheit 171 und/oder die erste Recheneinheit Cn1 weiterzuleiten,
wobei ein erster Multiplexer-Eingang des ersten Multiplexers 164 mit einem ersten PLL-Ausgang der ersten PLL 191 zur Übertragung eines ersten frequenzstabilisierten Taktsignals Tp11 in Richtung des ersten Multiplexer 164 verbunden ist, und wobei ein zweiter Multiplexer-Eingang des ersten Multiplexers 164 mit einem zweiten PLL-Ausgang der zweiten PLL 192 zur Übertragung eines zweiten frequenzstabilisierten Taktsignals Tp22 in Richtung des ersten Multiplexers 164 verbunden ist, und wobei das erste Umschaltsignal Tr1 vorgesehen ist, um damit den ersten Multiplexer 164 derart zu steuern, dass abhängig von einem Zustand des Umschaltsignals Tr1 mittels des ersten Multiplexers 164 entweder das erste frequenzstabilisierte Taktsignal Tp11 oder das zweite frequenzstabilisierte Taktsignal Tp22 an die erste Uhr 166 weiterleitbar ist, und wobei die erste Uhr 166 eingerichtet ist, um abhängig vom Zustand des Umschaltsignals Tr1 entweder das erste frequenzstabilisierte Taktsignal Tp11 oder das zweite frequenzstabilisierte Taktsignal Tp22 zur Erzeugung des ersten Uhrensignals Tc1 zu verarbeiten,
wobei mittels der ersten Umschaltsignalsendeeinheit 310 und mittels einer Zeitbotschaft-Sendeeinheit 314 bei einem Vorliegen eines vordefinierten und durch eine Zeitbotschaft-Sendeeinheit 314 festgelegten ersten Umschaltzeitpunktes Tx1 ein Zustandswechsel des ersten Umschaltsignals Tr1 vorgenommen wird,
wobei in dem Verfahren des Weiteren
   - in einem Verfahrensschritt-A infolge des Zustandswechsels des ersten Umschaltsignals Tr1 ausgelöst wird, dass zu dem ersten Umschaltzeitpunkt Tx1 mittels des ersten Multiplexers 164 eine Weiterleitung des zweiten frequenzstabilisierten Taktsignals Tp22 via erster Taktsignalleitung 168 zu der ersten Uhr 166 abgebrochen wird, und zu dem ersten Umschaltzeitpunkt Tx1 eine Weiter-leitung des ersten frequenzstabilisierten Taktsignals Tp11 via erster Taktsignalleitung 168 zu der ersten Uhr 166 bewirkt wird, und
   - in einem dem Schritt-A zeitlich nachgelagerten Verfahrensschritt-B eine erste Zeitdifferenz T1D derart ermittelt wird, dass als Minuend ein vordefinierter erster globaler Uhrenvergleichs-Zeitpunkt T1G, der auf der globalen Zeit-Skala CG1 dem ersten Umschaltzeitpunkt Tx1 nachfolgt, ausgewählt wird, und dass als Subtrahend ein gleichzeitig zu dem ersten globalen Uhrenvergleichszeit-punkt T1G vorliegender und der ersten lokalen Zeit-Skala CL1 zugeordneter erster lokaler Uhrenvergleichs-Zeitpunkt T1L ausgewählt wird, und die erste Zeit-differenz T1D den zeitlichen Abstand der globalen Startzeit TG0 von der ersten lokalen Startzeit TL0 widerspiegelt, und die erste Zeit-differenz T1D nachfolgend für eine weitere Verwendung in der Überprüfungsvorrichtung 10 und/oder für eine Verwendung in einer weiteren Überprüfungsvorrichtung bereitgestellt wird.

Erfindungsgemäß wird des Weiteren eine Überprüfungsvorrichtung 10 zum Testen mindestens eines ersten Regelungsgerätes vorgeschlagen, wobei die Überprüfungsvorrichtung 10 zumindest umfasst: eine erste Recheneinheit Cn1 zur Ausführung eines Modellcodes, wobei mittels des Modellcodes ein simuliertes Regelstreckensignal zur Stimulierung des Regelungsgerätes bereitstellbar ist und ein Aktorsignal des Regelungsgerätes bearbeitbar sind, und eine erste Zeitsignalwandlereinheit 300 aufweisend zumindest
(i) eine erste Zeitsignalschnittstelle G1 zur Aufnahme eines ersten Zeitsignals Ts1 einer globalen Zeitsignalquelle, die einer globalen Zeit-Skala zugeordnet ist,
   und
(ii) eine erste Umschaltsignalsendeeinheit 310, die eingerichtet ist, um ein erstes Umschaltsignal Tr1 zur Weitergabe an einen ersten Multiplexer 164 bereitzustellen, und
(iii) eine erste Taktsendeeinheit 312, die eingerichtet ist, um aus dem ersten Zeitsignal Ts1 ein erstes periodisches Taktsignal Tp1 zu erzeugen und das erste periodische Taktsignal Tp1 an eine erste PLL 191 auszugeben, und wobei die Überprüfungseinrichtung 10 des Weiteren umfasst:
   (a) einen ersten Oszillator 161, der eingerichtet ist, um ein zweites periodisches Taktsignals Tp2 zu erzeugen und das zweite periodische Taktsignal Tp2 an eine zweite PLL 192 auszugeben, und
   (b) eine erste Uhr 166, die einerseits mittels einer ersten Taktsignalleitung 168 mit dem ersten Multiplexer 164 verbunden ist und andererseits eingerichtet ist, um ein erstes Uhrensignal Tc1, das auf eine erste lokale Zeit-Skala CL1 bezogen ist, an eine erste Eingabe-Ausgabe-Einheit 171 und/oder die erste Recheneinheit Cn1 weiterzuleiten, wobei ein erster Multiplexer-Eingang des ersten Multiplexers 164 mit einem ersten PLL-Ausgang der ersten PLL 191 zur Übertragung eines ersten frequenzstabilisierten Taktsignals Tp11 in Richtung des ersten Multiplexer 164 verbunden ist, und
      wobei ein zweiter Multiplexer-Eingang des ersten Multiplexers 164 mit einem zweiten PLL-Ausgang der zweiten PLL 192 zur Übertragung eines zweiten frequenzstabilisierten Taktsignals Tp22 in Richtung des ersten Multiplexers 164 verbunden ist, und wobei das erste Umschaltsignal Tr1 vorgesehen ist, um damit den ersten Multiplexer 164 derart zu steuern, dass abhängig von einem Zustand des Umschaltsignals Tr1 mittels des ersten Multiplexers 164 entweder das erste frequenzstabilisierte Taktsignals Tp11 oder das zweite frequenzstabilisierte Taktsignals Tp22 an die erste Uhr 166 weiterleitbar ist, und wobei die erste Uhr 166 eingerichtet ist, um abhängig vom Zustand des Umschaltsignals Tr1 entweder das erste frequenzstabilisierte Taktsignals Tp11 oder das zweite frequenzstabilisierte Taktsignals Tp22 zur Erzeugung des ersten Uhrensignals Tc1 zu verarbeiten,
         wobei die erste Umschaltsignalsendeeinheit 310 eingerichtet ist, um mittels einer Zeitbotschaft-Sendeeinheit 314 bei einem Vorliegen eines vordefinierten und durch eine Zeitbotschaft-Sendeeinheit 314 festgelegten ersten Umschaltzeitpunktes Tx1 einen Zustandswechsel des ersten Umschaltsignals Tr1 vorzunehmen, und
         wobei die Überprüfungsvorrichtung 10 des Weiteren eingerichtet ist, um
            - in einem Verfahrensschritt-A infolge des Zustandswechsels des ersten Umschaltsignals Tr1 auszulösen, dass zu dem ersten Umschaltzeitpunkt Tx1 mittels des ersten Multiplexers 164 eine Weiterleitung des zweiten frequenzstabilisierten Taktsignals Tp22 via erster Taktsignalleitung 168 zu der ersten Uhr 166 abgebrochen wird, und zu dem ersten Umschaltzeitpunkt Tx1 eine Weiterleitung des ersten frequenzstabilisierten Taktsignals Tp11 via erster Taktsignalleitung 168 zu der ersten Uhr 166 bewirkt wird,
            und
            wobei die Überprüfungsvorrichtung 10 des Weiteren eingerichtet ist, um
            - in einem dem Schritt-A zeitlich nachgelagerten Verfahrensschritt-B eine erste Zeitdifferenz T1D derart zu ermitteln,
         dass als Minuend ein vordefinierter erster globaler Uhrenvergleichs-Zeitpunkt T1G, der auf der globalen Zeit-Skala CG1 dem ersten Umschaltzeitpunkt Tx1 nachfolgt, ausgewählt wird, und
         dass als Subtrahend ein gleichzeitig zu dem ersten globalen Uhrenvergleichszeitpunkt T1G vorliegender und der ersten lokalen Zeit-Skala CL1 zugeordneter erster lokaler Uhrenvergleichs-Zeitpunkt T1L ausgewählt wird,
         und die sich aus Minuend und Subtrahend ergebende erste Zeitdifferenz T1D den zeitlichen Abstand der globalen Startzeit TG0 von der ersten lokalen Startzeit TL0 widerspiegelt, und die erste Zeitdifferenz T1D nachfolgend für eine weitere Verwendung in der Überprüfungsvorrichtung 10 und/oder für eine Verwendung in einer weiteren Überprüfungsvorrichtung bereitgestellt wird.

Erfindungsgemäß wird des Weiteren ein Verbundsystem umfassend zumindest eine obige Überprüfungsvorrichtung (10) und eine weitere gleichwirkend zu einer Überprüfungsvorrichtung (10) ausgestaltete Überprüfungsvorrichtung vorgeschlagen, wobei die Überprüfungsvorrichtung (10) und die weitere Überprüfungsvorrichtung über ein Datenübertragungsmittel verbunden sind, und die Überprüfungsvorrichtung 10 und die weitere Überprüfungsvorrichtung via Datenübertragungsmittel
- zur Übertragung von mittels der erster Recheneinheit Cn1 berechneten Daten, und/oder
- zur Übertragung von mittels Ein-Ausgabe-Schnittstellen 173 erfassten Messdaten, und/oder
- zur Übertragung der obigen ersten Zeitdifferenz T1D von der ersten Überprüfungsvorrichtung an die weitere Überprüfungsvorrichtung eingerichtet sind.

Einer der Vorteile des erfindungsgemäßen Verfahrens und der erfindungsgemäßen Überprüfungsvorrichtung und des Verbundsystems ist es, dass damit die erste Recheneinheit und eine zweite Recheneinheit trotz eines zwischen den Recheneinheiten bestehenden Abstandes von ggf. einigen hundert Metern oder sogar vielen Kilometern auf vergleichsweise einfache Weise zu synchronisieren sind. Vorteilhafterweise können mittels der Erfindung die Überprüfungsvorrichtung und eine weitere Überprüfungsvorrichtung miteinander synchronisiert werden.

Ungewollte Sprünge des sich "normalerweise" in vordefinierten Zeitschritten ändernden ersten Uhrensignals sind mittels der Erfindung reduzierbar oder sogar gänzlich vermeidbar.

Soweit im Rahmen dieses Dokuments der Begriff "Synchronisierung" verwendet wird, ist stets eine zeitliche Synchronisierung gemeint. Eine sogenannte Winkelsynchronisierung baut häufig auf einer zeitlichen Synchronisierung auf. Die Winkelsynchronisierung ist allerdings nicht Gegenstand der vorliegenden Erfindung.

Der Begriff PLL ist ein gebräuchlicher Fachterminus, der aus der engl. Sprache abgeleitet wurde (PLL im Engl. "phase-locked loop") und seit mehreren Jahren auch im deutschen Sprachraum gebräuchlich ist. Als Synonym zu dem Begriff "PLL" wird alternativ auch der Begriff "Phasenregelschleife" oder der Begriff PLL-Baustein gebraucht.

Die PLL bzw. die PLLs (Mehrzahl) ist/sind bevorzugt zur Frequenzstabilierung und/oder zur Frequenzanpassung vorsehbar. Beispielsweise ist in einer bevorzugten Weiterbildung der Überprüfungsvorrichtung 10 vorgesehen, die durch das erste periodische taktsignal Tp1 disziplinierte erste PLL 191 derart auszugestalten, dass die Tp11-Frequenz des ersten frequenzstabilisierten Taktsignals Tp11 und die Tp22-Frequenz des zweiten frequenzstabilisierten Taktsignals Tp22 angeglichen werden, soweit dies ab dem ersten Umschaltzeitpunkt Tx1 noch nicht der Fall sein sollte.

Die Erfindung wird nachfolgend unter Bezugnahme auf die Zeichnung näher erläutert. Hierbei werden gleichartige Teile bzw. Signale mit identischen Bezeichnungen beschriftet. Die dargestellten Ausführungsformen sind stark schematisiert.

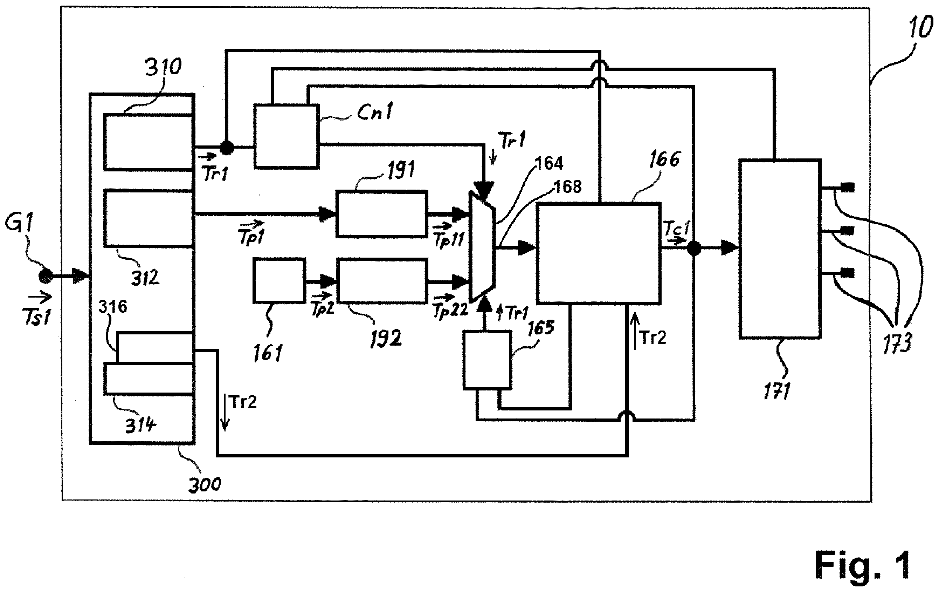

Die Abbildung der Figur 1 zeigt eine schematische Ansicht einer ersten Ausführungsform der erfindungsgemäßen Überprüfungsvorrichtung 10 zum Testen eines Regelungsgerätes, wobei das Regelungsgerät in der Figur 1 nicht dargestellt ist, sondern Eingabe-Ausgabe-Schnittstellen 173, die mit entsprechenden Schnittstellen des Regelungsgerätes während dessen Überprüfung verbunden sind.

In einer bevorzugten Ausführungsform des erfindungsgemäßen Verfahrens Werden oder wird die in Verfahrensschritt-B ermittelte erste Zeitdifferenz (T1D) und/oder das erste Uhrensignal (Tc1) an die erste Recheneinheit (Cn1) und/oder an die erste Eingabe-Ausgabe-Einheit (171) übermittelt.

In einer anderen Ausführungsform des erfindungsgemäßen Verfahrens wird der Verfahrensschritt-B mittels eines von einer zweiten Umschaltsignalsendeeinheit (316) ausgegebenen zweiten Umschaltsignals (Tr2) ausgelöst.

In der letztgenannten Ausführungsform ist es bevorzugt vorgesehen, dass das zweite Umschaltsignal (Tr2) an einem vordefinierten und in der Zeitsignalwandlereinheit (300) gespeicherten und zeitlich
- einerseits nach dem ersten Umschaltzeitpunkt (Tx1) liegenden und
- andererseits nach einem Ablauf eines ersten Einschwing-Zeitintervalls (Tosc) der ersten PLL (191) liegenden Zeitpunkt
an die erste Uhr (166) und/oder an die erste Recheneinheit (Cn1) gesendet wird.

In einer anderen Weiterbildung des erfindungsgemäßen Verfahrens ist die Überprüfungsvorrichtung (10) mit einer weiteren Überprüfungsvorrichtung via Datenverbindungsmittel verbunden wird, und die weitere Überprüfungsvorrichtung ist eine gleichartige Entsprechung der Überprüfungsvorrichtung.

In einer besonders bevorzugten Weiterbildung des erfindungsgemäßen Verfahrens fließt die erste Zeitdifferenz (T1D) in Berechnungen der ersten Recheneinheit (Cn1) ein um einen zeitlich nach dem ersten globalen Uhrenvergleichs-Zeitpunkt liegenden (a) beliebigen Zeitpunkt auf der globalen Zeit-Skala (CG1) in einen zugehörigen Zeitpunkt der ersten lokalen Zeit-Skala (CL1) umzurechnen, oder (b) beliebigen Zeitpunkt auf der lokalen Zeit-Skala (CL1) in einen zugehörigen Zeitpunkt der globalen Zeit-Skala (CG1) umzurechnen.

Bevorzugt ist des Weiteren die erste Recheneinheit Cn1 und/oder die erste Eingabe-Ausgabe-Einheit 171 eingerichtet, um das erste Uhrensignal Tc1 mit berechneten Daten der ersten Recheneinheit Cn1 und/oder mit Daten, die via der Eingabe-Ausgabe-Schnittstellen 173 der ersten Eingabe-Ausgabe-Einheit 171 empfangen wurden, zu verknüpfen.

Die Zeitbotschaft-Sendeeinheit 314 ist bevorzugt eingerichtet, um insbesondere zyklisch jeweils eine Zeitbotschaft, also digitale Daten jeweils umfassend eine kodierte aktuelle Zeitangabe, die auf eine globale Zeit-Skala bezogen ist, auszusenden. Die Zeitbotschaft wird bevorzugt an die erste Recheneinheit Cn1 und/oder an die erste Uhr 166 und/oder an eine optional vorsehbare Multiplexer-Steuereinheit 165 übertragen.

Die globale Zeit-Skala CG1 weist eine globale Startzeit TG0 auf, die einen vordefinierten und insbesondere für mathematische Zwecke festgelegten Anfang einer globalen Zeitrechnung der globalen Zeitsignalquelle repräsentiert.

Die erste lokale Zeit-Skala weist eine erste lokale Startzeit TL0 auf, die einen vordefinierten Anfang einer lokalen Zeitrechnung der ersten Uhr 166 der Überprüfungsvorrichtung 10 repräsentiert.

In einer bevorzugten Ausführungsform der erfindungsgemäßen Vorrichtung ist die globale Zeitquelle eine Zeitsignalquelle eines globalen Navigationssatellitensystems. Dabei ist es bevorzugt, wenn das globale Navigationssatellitensystem dem Globalen Positionsbestimmungs-System (GPS) oder dem GLONASS- oder dem GALLILEO- oder dem BEIDOU- oder dem GAGAN- oder dem IRNSS- oder dem QZSS- Navigationssatellitensystem entspricht.

Die globale Zeitquelle umfasst bevorzugt mehrere Satelliten.

Ergänzend sei erwähnt, dass die bekannten globalen Navigationssatellitensysteme primär zur Positionsbestimmung und Navigation auf der Erde und in der Luft dienen, jedoch die Zeitsignale der globalen Navigationssatellitensysteme für weitere Anwendungen verwendbar sind, wie in dem vorliegenden Dokument dargelegt.

Zu den bekanntesten globalen Navigationssatellitensystemen gehören:
- GPS, also das "Global Positioning System" der Vereinigten Staaten von Amerika;
- GLONASS, also das "GLObal NAvigation Satellite System" der Russischen Föderation;
- Galileo der Europäischen Union und
- Beidou der Volksrepublik China.

Der Vollausbau von Beidou und Galileo wird in den kommenden Jahren erwartet.

Die sogenannte GPS-Zeit entstammt dem Zeitsystem der Navigationssatelliten des Global Positioning Systems. Es entspricht - bis auf eine geringe Abweichung von wenigen Sekunden - der internationalen Atomzeit, abgekürzt mit TAI. Gegenüber der Koordinierten Weltzeit, genannt UTC, weicht die GPS-Zeit ebenfalls um einige Sekunden ab.

Im Rahmen der mit GPS übertragenen Nutzdaten erfolgt in einem eigens dafür vorgesehenen Datenfeld eine Übertragung der aktuellen Differenz der GPS-Zeit zur UTC. GPS-Empfänger können durch Subtraktion der entsprechenden Anzahl von Schaltsekunden automatisch die UTC-Uhrzeit anzeigen bzw. zur Verfügung stellen. GPS-Empfänger eignen sich somit für die Verwendung in einer Zeitsignalwandlereinheit 300, weil diese das erste Zeitsignal Ts1 der globalen GPS-Zeitsignalquelle zur weiteren Verwendung für die Überprüfungsvorrichtung verfügbar machen.

Bevorzugt weist die erfindungsgemäße Überprüfungsvorrichtung (10) eine Eignung auf, um eine der Weiterbildungen oder eine der Ausführungsformen des erfindungsgemäßen Verfahrens auszuführen.

In einer Weiterbildung der erfindungsgemäßen Überprüfungsvorrichtung (10) ist die erste Recheneinheit (Cn1) und/oder die erste Eingabe-Ausgabe-Einheit (171) eingerichtet sind, um das erste Uhrensignal (Tc1) mit berechneten Daten der ersten Recheneinheit (Cn1) und/oder mit Daten, die via der Eingabe-Ausgabe-Schnittstellen (173) der ersten Eingabe-Ausgabe-Einheit (171) empfangen wurden, zu verknüpfen.

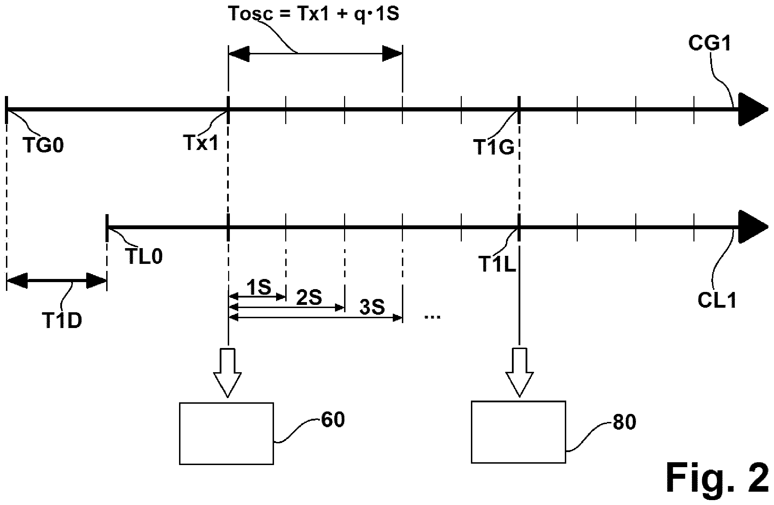

Die Figur 2 dient zur weiteren Veranschaulichung der Erfindung bzw. der Weiterbildungen oder Ausgestaltungen der Erfindung.

Es werden anhand eines in Figur 2 dargestellten Ausführungsbeispiels die in dem Ausführungsbeispiel vorliegende globale Zeit-Skala CG1 und die vorliegende erste lokale Zeit-Skala CL1 schematisch gegenübergestellt. Zu erkennen ist insbesondere, dass mit dem ersten Umschaltzeitpunkt Tx1 eine erste Menge 60 von Verfahrensschritten gemäß der entsprechenden Verfahrensmerkmale auslöst wird und mit dem ersten globalen Uhrenvergleichs-Zeitpunkt T1G eine zweite Menge 80 von Verfahrensschritten gemäß der entsprechenden Verfahrensmerkmale auslöst wird.

Bevorzugt liegt ab dem ersten Umschaltzeitpunkt Tx1 eine im Wesentlichen identische Taktung aller Uhren in dem Verbundsystem vor.

Vorteilhafterweise ist es mittels der Erfindung unter Verwendung kostengünstiger Mittel insbesondere ermöglicht, eine/mehrere Überprüfungsvorrichtung/en bzw. deren Uhr/Uhren mit der globalen Zeit-Skala zu verknüpfen und somit zu synchronisieren.

## Patentansprüche

1. Verfahren zur Synchronisation einer Überprüfungsvorrichtung (10), wobei die Überprüfungsvorrichtung (10) zum Testen mindestens eines ersten Regelungsgerätes eingerichtet ist und die Überprüfungsvorrichtung (10) zumindest umfasst: eine erste Recheneinheit (Cn1) zur Ausführung eines Modellcodes, wobei mittels des Modellcodes ein simuliertes Regelstreckensignal zur Stimulierung des Regelungsgerätes bereitstellbar ist und ein Aktorsignal des Regelungsgerätes bearbeitbar ist, und eine erste Zeitsignalwandlereinheit (300) aufweisend zumindest
(i) eine erste Zeitsignalschnittstelle (G1) zur Aufnahme eines ersten Zeitsignals (Ts1) einer globalen Zeitsignalquelle, die einer globalen Zeit-Skala zugeordnet ist, und
(ii) eine erste Umschaltsignalsendeeinheit (310), die eingerichtet ist, um ein erstes Umschaltsignal (Tr1) zur Weitergabe an einen ersten Multiplexer (164) bereitzustellen, und
(iii) eine erste Taktsendeeinheit (312), die eingerichtet ist, um aus dem ersten Zeitsignal (Ts1) ein erstes periodisches Taktsignal (Tp1) zu erzeugen und das erste periodische Taktsignal (Tp1) an eine erste PLL (191) auszugeben, und wobei die Überprüfungseinrichtung (10) des Weiteren umfasst:
(a) einen ersten Oszillator (161), der eingerichtet ist, um ein zweites periodisches Taktsignals (Tp2) zu erzeugen und das zweite periodische Taktsignal (Tp2) an eine zweite PLL (192) auszugeben, und
(b) eine erste Uhr (166), die einerseits mittels einer ersten Taktsignalleitung (168) mit dem ersten Multiplexer (164) verbunden ist und andererseits eingerichtet ist, um ein erstes Uhrensignal (Tc1), das auf eine erste lokale Zeit-Skala (CL1) bezogen ist, an eine erste Eingabe-Ausgabe-Einheit (171) und/oder die erste Recheneinheit (Cn1) weiterzuleiten,
wobei ein erster Multiplexer-Eingang des ersten Multiplexers (164) mit einem ersten PLL-Ausgang der ersten PLL (191) zur Übertragung eines ersten frequenzstabilisierten Taktsignals (Tp11) in Richtung des ersten Multiplexer (164) verbunden ist, und
wobei ein zweiter Multiplexer-Eingang des ersten Multiplexers (164) mit einem zweiten PLL-Ausgang der zweiten PLL (192) zur Übertragung eines zweiten frequenzstabilisierten Taktsignals (Tp22) in Richtung des ersten Multiplexers (164) verbunden ist, und wobei das erste Umschaltsignal (Tr1) vorgesehen ist, um damit den ersten Multiplexer (164) derart zu steuern, dass abhängig von einem Zustand des Umschaltsignals (Tr1) mittels des ersten Multiplexers (164) entweder das erste frequenzstabilisierte Taktsignal (Tp11) oder das zweite frequenzstabilisierte Taktsignal (Tp22) an die erste Uhr (166) weiterleitbar ist, und wobei die erste Uhr (166) eingerichtet ist, um abhängig vom Zustand des Umschaltsignals (Tr1) entweder das erste frequenzstabilisierte Taktsignal (Tp11) oder das zweite frequenzstabilisierte Taktsignal (Tp22) zur Erzeugung des ersten Uhrensignals (Tc1) zu verarbeiten,
wobei mittels der ersten Umschaltsignalsendeeinheit (310) und mittels einer Zeitbotschaft-Sendeeinheit (314) bei einem Vorliegen eines vordefinierten und durch eine Zeitbotschaft-Sendeeinheit (314) festgelegten ersten Umschaltzeitpunktes (Tx1) ein Zustandswechsel des ersten Umschaltsignals (Tr1) vorgenommen wird,
wobei in dem Verfahren des Weiteren
- in einem Verfahrensschritt-A infolge des Zustandswechsels des ersten Umschaltsignals (Tr1) ausgelöst wird, dass zu dem ersten Umschaltzeitpunkt (Tx1) mittels des ersten Multiplexers (164) eine Weiterleitung des zweiten frequenzstabilisierten Taktsignals (Tp22) via erster Taktsignalleitung (168) zu der ersten Uhr (166) abgebrochen wird, und zu dem ersten Umschaltzeitpunkt (Tx1) eine Weiterleitung des ersten frequenzstabilisierten Taktsignals (Tp11) via erster Taktsignalleitung (168) zu der ersten Uhr (166) bewirkt wird, und
- in einem dem Schritt-A zeitlich nachgelagerten Verfahrensschritt-B eine erste Zeitdifferenz (T1D) derart ermittelt wird, dass als Minuend ein vordefinierter erster globaler Uhrenvergleichs-Zeitpunkt (T1G), der auf der globalen Zeit-Skala (CG1) dem ersten Umschaltzeitpunkt (Tx1) nachfolgt, ausgewählt wird, und dass als Subtrahend ein gleichzeitig zu dem ersten globalen Uhrenvergleichszeitpunkt (T1G) vorliegender und der ersten lokalen Zeit-Skala (CL1) zugeordneter erster lokaler Uhrenvergleichs-Zeitpunkt (T1L) ausgewählt wird, und die erste Zeitdifferenz (T1D) den zeitlichen Abstand der globalen Startzeit (TGO) von der ersten lokalen Startzeit (TL0) widerspiegelt, und die erste Zeitdifferenz (T1D) nachfolgend für eine weitere Verwendung in der Überprüfungsvorrichtung (10) und/oder für eine Verwendung in einer weiteren Überprüfungsvorrichtung bereitgestellt wird.

2. Verfahren nach Anspruch 1, **dadurch gekennzeichnet, dass** die in Verfahrensschritt-B ermittelte erste Zeitdifferenz (T1D) und/oder das erste Uhrensignal (Tc1) an die erste Recheneinheit (Cn1) und/oder an die erste Eingabe-Ausgabe-Einheit (171) übermittelt werden oder wird.

3. Verfahren nach Anspruch 1 oder Anspruch 2, **dadurch gekennzeichnet, dass** der Verfahrensschritt-B mittels eines von einer zweiten Umschaltsignalsendeeinheit (316) ausgegebenen zweiten Umschaltsignals (Tr2) ausgelöst wird.

4. Verfahren nach Anspruch 3, **dadurch gekennzeichnet, dass** das zweite Umschaltsignal (Tr2) an einem vordefinierten und in der Zeitsignalwandlereinheit (300) gespeicherten und zeitlich
- einerseits nach dem ersten Umschaltzeitpunkt (Tx1) liegenden und
- andererseits nach einem Ablauf eines ersten Einschwing-Zeitintervalls (Tosc) der ersten PLL (191) liegenden Zeitpunkt
an die erste Uhr (166) und/oder an die erste Recheneinheit (Cn1) gesendet wird.

5. Verfahren nach einem der Ansprüche 1 bis 4, **dadurch gekennzeichnet, dass** die Überprüfungsvorrichtung (10) mit einer weiteren Überprüfungsvorrichtung via Datenverbindungsmittel verbunden wird, und die weitere Überprüfungsvorrichtung eine gleichartige Entsprechung der Überprüfungsvorrichtung ist.

6. Verfahren nach einem der Ansprüche 1 bis 5, **dadurch gekennzeichnet, dass** die erste Zeitdifferenz (T1D) in Berechnungen der ersten Recheneinheit (Cn1) einfließt um einen zeitlich nach dem ersten globalen Uhrenvergleichs-Zeitpunkt liegenden
(a) beliebigen Zeitpunkt auf der globalen Zeit-Skala (CG1) in einen zugehörigen Zeitpunkt der ersten lokalen Zeit-Skala (CL1) umzurechnen, oder
(b) beliebigen Zeitpunkt auf der lokalen Zeit-Skala (CL1) in einen zugehörigen Zeitpunkt der globalen Zeit-Skala (CG1) umzurechnen.

7. Überprüfungsvorrichtung (10) zum Testen mindestens eines ersten Regelungsgerätes, wobei die Überprüfungsvorrichtung (10) zumindest umfasst: eine erste Recheneinheit (Cn1) zur Ausführung eines Modellcodes, wobei mittels des Modellcodes ein simuliertes Regelstreckensignal zur Stimulierung des Regelungsgerätes bereitstellbar ist und ein Aktorsignal des Regelungsgerätes bearbeitbar sind, und eine erste Zeitsignalwandlereinheit (300) aufweisend zumindest
(i) eine erste Zeitsignalschnittstelle (G1) zur Aufnahme eines ersten Zeitsignals (Ts1) einer globalen Zeitsignalquelle, die einer globalen Zeit-Skala zugeordnet ist,
und
(ii) eine erste Umschaltsignalsendeeinheit (310), die eingerichtet ist, um ein erstes Umschaltsignal (Tr1) zur Weitergabe an einen ersten Multiplexer (164) bereitzustellen, und
(iii) eine erste Taktsendeeinheit (312), die eingerichtet ist, um aus dem ersten Zeitsignal (Ts1) ein erstes periodisches Taktsignal (Tp1) zu erzeugen und das erste periodische Taktsignal (Tp1) an eine erste PLL (191) auszugeben, und wobei die Überprüfungseinrichtung (10) des Weiteren umfasst:
(a) einen ersten Oszillator (161), der eingerichtet ist, um ein zweites periodisches Taktsignals (Tp2) zu erzeugen und das zweite periodische Taktsignal (Tp2) an eine zweite PLL (192) auszugeben, und
(b) eine erste Uhr (166), die einerseits mittels einer ersten Taktsignalleitung (168) mit dem ersten Multiplexer (164) verbunden ist und andererseits eingerichtet ist, um ein erstes Uhrensignal (Tc1), das auf eine erste lokale Zeit-Skala (CL1) bezogen ist, an eine erste Eingabe-Ausgabe-Einheit (171) und/oder die erste Recheneinheit (Cn1) weiterzuleiten,
wobei ein erster Multiplexer-Eingang des ersten Multiplexers (164) mit einem ersten PLL-Ausgang der ersten PLL (191) zur Übertragung eines ersten frequenzstabilisierten Taktsignals (Tp11) in Richtung des ersten Multiplexer (164) verbunden ist, und
wobei ein zweiter Multiplexer-Eingang des ersten Multiplexers (164) mit einem zweiten PLL-Ausgang der zweiten PLL (192) zur Übertragung eines zweiten frequenzstabilisierten Taktsignals (Tp22) in Richtung des ersten Multiplexers (164) verbunden ist, und wobei das erste Umschaltsignal (Tr1) vorgesehen ist, um damit den ersten Multiplexer (164) derart zu steuern, dass abhängig von einem Zustand des Umschaltsignals (Tr1) mittels des ersten Multiplexers (164) entweder das erste frequenzstabilisierte Taktsignals (Tp11) oder das zweite frequenzstabilisierte Taktsignals (Tp22) an die erste Uhr (166) weiterleitbar ist, und wobei die erste Uhr (166) eingerichtet ist, um abhängig vom Zustand des Umschaltsignals (Tr1) entweder das erste frequenzstabilisierte Taktsignals (Tp11) oder das zweite frequenzstabilisierte Taktsignals (Tp22) zur Erzeugung des ersten Uhrensignals (Tc1) zu verarbeiten,
wobei die erste Umschaltsignalsendeeinheit (310) eingerichtet ist, um mittels einer Zeitbotschaft-Sendeeinheit (314) bei einem Vorliegen eines vordefinierten und durch eine Zeitbotschaft-Sendeeinheit (314) festgelegten ersten Umschaltzeitpunktes (Tx1) einen Zustandswechsel des ersten Umschaltsignals (Tr1) vorzunehmen, und
wobei die Überprüfungsvorrichtung (10) des Weiteren eingerichtet ist, um
- in einem Verfahrensschritt-A infolge des Zustandswechsels des ersten Umschaltsignals (Tr1) auszulösen, dass zu dem ersten Umschaltzeitpunkt (Tx1) mittels des ersten Multiplexers (164) eine Weiterleitung des zweiten frequenzstabilisierten Taktsignals (Tp22) via erster Taktsignalleitung (168) zu der ersten Uhr (166) abgebrochen wird, und zu dem ersten Umschaltzeitpunkt (Tx1) eine Weiterleitung des ersten frequenzstabilisierten Taktsignals (Tp11) via erster Taktsignalleitung (168) zu der ersten Uhr (166) bewirkt wird,
und
wobei die Überprüfungsvorrichtung (10) des Weiteren eingerichtet ist, um
- in einem dem Schritt-A zeitlich nachgelagerten Verfahrensschritt-B eine erste Zeitdifferenz (T1D) derart zu ermitteln,
dass als Minuend ein vordefinierter erster globaler Uhrenvergleichs-Zeitpunkt (T1G), der auf der globalen Zeit-Skala (CG1) dem ersten Umschaltzeitpunkt (Tx1) nachfolgt, ausgewählt wird, und
dass als Subtrahend ein gleichzeitig zu dem ersten globalen Uhrenvergleichszeitpunkt (T1G) vorliegender und der ersten lokalen Zeit-Skala (CL1) zugeordneter erster lokaler Uhrenvergleichs-Zeitpunkt (T1L) ausgewählt wird,
und die sich aus Minuend und Subtrahend ergebende erste Zeitdifferenz (T1D) den zeitlichen Abstand der globalen Startzeit (TGO) von der ersten lokalen Startzeit (TL0) widerspiegelt, und die erste Zeitdifferenz (T1D) nachfolgend für eine weitere Verwendung in der Überprüfungsvorrichtung (10) und/oder für eine Verwendung in einer weiteren Überprüfungsvorrichtung bereitgestellt wird.

8. Überprüfungsvorrichtung (10) nach Anspruch 7, **gekennzeichnet durch** eine Eignung, ein Verfahren nach einem der Ansprüche 2 bis 6 auszuführen.

9. Überprüfungsvorrichtung (10) nach Anspruch 7 oder 8, **dadurch gekennzeichnet, dass** die erste Recheneinheit (Cn1) und/oder die erste Eingabe-Ausgabe-Einheit (171) eingerichtet sind, um das erste Uhrensignal (Tc1) mit berechneten Daten der ersten Recheneinheit (Cn1) und/oder mit Daten, die via der Eingabe-Ausgabe-Schnittstellen (173) der ersten Eingabe-Ausgabe-Einheit (171) empfangen wurden, zu verknüpfen.

10. Verbundsystem umfassend zumindest eine Überprüfungsvorrichtung (10) nach einem der Ansprüche 7 bis 9 und eine weitere gleichwirkend zu einer Überprüfungsvorrichtung (10) nach einem der Ansprüche 7 bis 9 ausgestaltete Überprüfungsvorrichtung, wobei die Überprüfungsvorrichtung (10) und die weitere Überprüfungsvorrichtung über ein Datenübertragungsmittels verbunden sind, und die Überprüfungsvorrichtung (10) und die weitere Überprüfungsvorrichtung via Datenübertragungsmittel
- zur Übertragung von mittels der erster Recheneinheit (Cn1) berechneten Daten, und/oder
- zur Übertragung von mittels Ein-Ausgabe-Schnittstellen (173) erfassten Messdaten, und/oder
- zur Übertragung der ersten Zeitdifferenz (T1D) von der ersten Überprüfungsvorrichtung an die weitere Überprüfungsvorrichtung eingerichtet sind.

## Claims

1. A method for synchronizing an testing device (10), the testing device (10) being set up for testing at least one first control device and the testing device (10) comprising at least: a first processing unit (Cn1) for executing a model code, a simulated control section signal being able to be provided by means of the model code for stimulating the control device and an actuator signal of the control device being able to be processed, and a first time signal converter unit (300) comprising at least
(i) a first time signal interface (G1) for receiving a first time signal (Ts1) of a global time signal source associated with a global time scale, and
(ii) a first switchover signal transmitting unit (310) set up for providing a first switchover signal (Tr1) for forwarding to a first multiplexer (164), and
(iii) a first timing transmitting unit (312) set up for generating a first periodic timing signal (Tp1) from the first time signal (Ts1) and for outputting the first periodic timing signal (Tp1) to a first PLL (191), and the testing device (10) further comprising:
(a) a first oscillator (161) set up for generating a second periodic timing signal (Tp2) and for outputting the second periodic timing signal (Tp2) to a second PLL (192), and
(b) a first clock (166), firstly connected to the first multiplexer (164) by means of a first timing signal line (168) and secondly set up for forwarding a first clock signal (Tc1) related to a first local time scale (CL1) to a first input/output unit (171) and/or to the first processing unit (Cn1),
a first multiplexer input of the first multiplexer (164) being connected to a first PLL output of the first PLL (191) for transferring a first frequency-stabilized timing signal (Tp11) in the direction of the first multiplexer (164), and
a second multiplexer input of the first multiplexer (164) being connected to a second PLL output of the second PLL (192) for transferring a second frequency-stabilized timing signal (Tp22) in the direction of the first multiplexer (164), and
the first switchover signal (Tr1) being provided for thereby controlling the first multiplexer (164) such that either the first frequency-stabilized timing signal (Tp11) or the second frequency-stabilized timing signal (Tp22) can be forwarded to the first clock (166) by means of the first multiplexer (164) depending on the state of the switchover signal (Tr1), and the first clock (166) being set up for processing either the first frequency-stabilized timing signal (Tp11) or the second frequency-stabilized timing signal (Tp22), depending on the state of the switchover signal (Tr1), for generating the first clock signal (Tc1),
wherein a state change of the first switchover signal (Tr1) is made by means of the first switchover signal transmitting unit (310) and by means of a time message transmitting unit (314) when a predefined first switchover point in time (Tx1) defined by a time message transmitting unit (314) is present,
furthermore, in the method,
- it is triggered in a method step A, as a result of the state change of the first switchover signal (Tr1), that forwarding of the second frequency-stabilized timing signal (Tp22) to the first clock (166) via a first timing signal line (168) is interrupted at the first switchover point in time (Tx1) by means of the first multiplexer (164), and that forwarding of the first frequency-stabilized timing signal (Tp11) to the first clock (166) via the first timing signal line (168) is brought about at the first switchover point in time (Tx1), and
- in a step B following after step A,
a first time difference (T1D) is determined such that a predefined first global clock comparison point in time (T1G) following the first switchover point in time (Tx1) on the global time scale (CG1) is selected as the minuend, and that a first local clock comparison point in time (T1L) simultaneously present at the first global clock comparison point in time (T1G) and associated with the first local time scale (CL1) is selected as the subtrahend, and the first time different (T1D) reflects the difference in time of the global starting time (TGO) from the first local starting time (TLO), and the first time different (T1D) is subsequently provided for further use in the testing device (10) and/or for use in a further testing device.

2. The method according to claim 1, **characterized in that** the first time difference (T1D) determined in method step B and/or the first clock signal (Tc1) is or are transmitted to the first processing unit (Cn1) and/or to the first input/output unit (171).

3. The method according to claim 1 or 2, **characterized in that** the method step B is triggered by means of a second switchover signal (Tr2) output by a second switchover signal transmitting unit (316).

4. The method according to claim 3, **characterized in that** the second switchover signal (Tr2), at a predefined point in time saved in the time signal converting unit (300) and
- firstly after the first switchover point in time (Tx1), and
- secondly after the expiring of a first settling time interval (Tosc) of the first PLL (191), is sent to the first clock (166) and/or to the first processing unit (Cn1).

5. The method according to any one of the claims 1 through 4, **characterized in that** the testing device (10) is connected to a further testing device via data connection means and the further testing device is an identical version of the testing device.

6. The method according to any one of the claims 1 through 5, **characterized in that** the first time different (T1D) flows into calculations of the first processing unit (Cn1) in order to convert
(a) an arbitrary point in time after the first global clock comparison point in time on the global time scale (CG1) into an associated point in time of the first local time scale (CL1),
(b) an arbitrary point in time after the first global clock comparison point in time on the local time scale (CL1) into an associated point in time of the global time scale (CG1).

7. A testing device (10) for testing at least one first control device, the test device (10) comprising at least: a first processing unit (Cn1) for executing a model code, a simulated control section signal being able to be provided by means of the model code for stimulating the control device and an actuator signal of the control device being able to be processed, and a first time signal converter unit (300) comprising at least
(i) a first time signal interface (G1) for receiving a first time signal (Ts1) of a global time signal source associated with a global time scale,
and
(ii) a first switchover signal transmitting unit (310) set up for providing a first switchover signal (Tr1) for forwarding to a first multiplexer (164), and
(iii) a first timing transmitting unit (312) set up for generating a first periodic timing signal (Tp1) from the first time signal (Ts1) and for outputting the first periodic timing signal (Tp1) to a first PLL (191), and the testing device (10) further comprising:
(a) a first oscillator (161) set up for generating a second periodic timing signal (Tp2) and for outputting the second periodic timing signal (Tp2) to a second PLL (192), and
(b) a first clock (166), firstly connected to the first multiplexer (164) by means of a first timing signal line (168) and secondly set up for forwarding a first clock signal (Tc1) related to a first local time scale (CL1) to a first input/output unit (171) and/or to the first processing unit (Cn1),
a first multiplexer input of the first multiplexer (164) being connected to a first PLL output of the first PLL (191) for transferring a first frequency-stabilized timing signal (Tp11) in the direction of the first multiplexer (164), and
a second multiplexer input of the first multiplexer (164) being connected to a second PLL output of the second PLL (192) for transferring a second frequency-stabilized timing signal (Tp22) in the direction of the first multiplexer (164), and
the first switchover signal (Tr1) being provided for thereby controlling the first multiplexer (164) such that either the first frequency-stabilized timing signal (Tp11) or the second frequency-stabilized timing signal (Tp22) can be forwarded to the first clock (166) by means of the first multiplexer (164) depending on the state of the switchover signal (Tr1), and the first clock (166) being set up for processing either the first frequency-stabilized timing signal (Tp11) or the second frequency-stabilized timing signal (Tp22), depending on the state of the switchover signal (Tr1), for generating the first clock signal (Tc1),
the first switchover signal transmitting unit (310) being set up for making a state change of the first switchover signal (Tr1) by means of a time message transmitting unit (314) when a predefined first switchover point in time (Tx1) defined by a time message transmitting unit (314) is present,
the testing device (10) being further set up for
- triggering, in a method step A, as a result of the state change of the first switchover signal (Tr1), that forwarding of the second frequency-stabilized timing signal (Tp22) to the first clock (166) via a first timing signal line (168) is interrupted at the first switchover point in time (Tx1) by means of the first multiplexer (164), and that forwarding of the first frequency-stabilized timing signal (Tp11) to the first clock (166) via the first timing signal line (168) is brought about at the first switchover point in time (Tx1),
and
the testing device (10) being further set up for
- determining a first time difference (T1D) in a method step B after step A, such that
a predefined first global clock comparison point in time (T1G) following the first switchover point in time (Tx1) on the global time scale (CG1) is selected as the minuend, and
that a first local clock comparison point in time (T1L) simultaneously present at the first global clock comparison point in time (T1G) and associated with the first local time scale (CL1) is selected as the subtrahend,
and the first time difference (T1D) resulting from the minuend and subtrahend reflects the time difference between the global starting time (TGO) and the first local starting time (TLO), and the first time difference (T1D) is subsequently provided for further use in the testing device (10) and/or for use in a further testing device.

8. The testing device (10) according to claim 7, **characterized by** being suitable for performing a method according to any one of the claims 2 through 6.

9. The testing device (10) according to claim 7 or 8, **characterized in that** the first processing unit (Cn1) and/or the first input/output unit (171) are set up for linking the first clock signal (Tc1) to calculated data of the first processing unit (Cn1) and/or to data received by means of the input/output interfaces (173) of the first input/output unit (171).

10. A composite system comprising at least one testing device (10) according to any one of the claims 7 through 9 and further functionally identical testing device implemented as a testing device (10) according to any one of the claims 7 through 9, the testing device (10) and the further testing device being connected by means of a data transmitting means and the testing device (10) and the further testing device being set up for
- transferring, by means of data transferring means, data calculated by means of the first processing unit (Cn1), and/or
- transferring, by means of data transferring means, measurement data captured by means of input/output interfaces (173), and/or
- transferring, by means of data transferring means, the first time difference (T1D) from the first testing device to the further testing device.

## Revendications

1. Procédé pour la synchronisation d'un dispositif de vérification (10), dans lequel le dispositif de vérification (10) est configuré pour tester au moins un premier appareil de régulation et le dispositif de vérification (10) comprend au moins : une première unité de calcul (Cn1) pour l'exécution d'un code de modèle, dans lequel un signal simulé de système commandé peut être mis à disposition au moyen du code de modèle pour la stimulation de l'appareil de régulation et un signal d'actionneur de l'appareil de régulation peut être traité, et une première unité de convertisseur (300) de signaux temporels présentant au moins
(i) une première interface (G1) de signaux temporels pour recevoir un premier signal temporel (Ts1) d'une source de signaux temporels globale qui est associée à une échelle de temps globale, et
(ii) une première unité d'émission (310) de signaux de commutation qui est configurée pour fournir un premier signal de commutation (Tr1) destiné à être transmis à un premier multiplexeur (164),
et
(iii) une première unité d'émission d'horloge (312) qui est configurée pour générer un premier signal de commande temporelle périodique (Tp1) à partir du premier signal temporel (Ts1) et pour délivrer le premier signal de commande temporelle périodique (Tp1) à une première PLL (191), et dans lequel le dispositif de vérification (10) comprend en outre :
(a) un premier oscillateur (161) qui est configuré pour générer un deuxième signal de commande temporelle périodique (Tp2) et pour délivrer le deuxième signal de commande temporelle périodique (Tp2) à une deuxième PLL (192), et
(b) une première horloge (166) qui, d'une part, est reliée au premier multiplexeur (164) au moyen d'une première ligne (168) de signal de commande temporelle et, d'autre part, est configurée pour transmettre un premier signal d'horloge (Tc1) relatif à une première échelle de temps locale (CL1) à une première unité d'entrée-sortie (171) et/ou à la première unité de calcul (Cn1),
dans lequel une première entrée de multiplexeur du premier multiplexeur (164) est connectée à une première sortie PLL de la première PLL (191) pour transmettre un premier signal de commande temporelle stabilisé en fréquence (Tp11) dans la direction du premier multiplexeur (164), et dans lequel une deuxième entrée de multiplexeur du premier multiplexeur (164) est connectée à une deuxième sortie PLL de la deuxième PLL (192) pour transmettre un deuxième signal de commande temporelle stabilisé en fréquence (Tp22) vers le premier multiplexeur (164), et dans lequel le premier signal de commutation (Tr1) est prévu pour, avec lui, commander le premier multiplexeur (164) de sorte qu'en fonction d'un état du signal de commutation (Tr1), soit le premier signal de commande temporelle stabilisé en fréquence (Tp11) soit le deuxième signal de commande temporelle stabilisé en fréquence (Tp22) peut être transmis à la première horloge (166) au moyen du premier multiplexeur (164), et dans lequel la première horloge (166) est configurée pour, en fonction de l'état du signal de commutation (Tr1), traiter soit le premier signal de commande temporelle stabilisé en fréquence (Tp11), soit le deuxième signal de commande temporelle stabilisé en fréquence (Tp22) afin de générer le premier signal d'horloge (Tc1),
dans lequel un changement d'état du premier signal de commutation (Tr1) est effectué au moyen de la première unité d'émission (310) de signaux de commutation et au moyen d'une unité d'émission (314) de message temporel en cas d'existence d'un premier instant de commutation (Tx1) prédéfini et fixé par une unité d'émission (314) de message temporel,
sachant que dans le procédé, par ailleurs,
- dans une étape de procédé A, à la suite du changement d'état du premier signal de commutation (Tr1), il est déclenché qu'une retransmission du deuxième signal de commande temporelle stabilisé en fréquence (Tp22) via la première ligne (168) de signal de commande temporelle vers la première horloge (166) est interrompue au premier instant de commutation (Tx1) au moyen du premier multiplexeur (164), et qu'une retransmission du premier signal de commande temporelle stabilisé en fréquence (Tp11) via la première ligne (168) de signal de commande temporelle vers la première horloge (166) est provoquée au premier instant de commutation (Tx1), et
- dans une étape de procédé B postérieure à l'étape A, une première différence de temps (T1D) est déterminée de sorte que soit sélectionné comme diminuende un premier instant de comparaison d'horloges global prédéfini (T1G), qui est postérieur au premier instant de commutation (Tx1) sur l'échelle de temps globale (CG1), et que soit sélectionné comme diminuteur un premier instant de comparaison d'horloges local (T1L) existant en même temps que le premier instant de comparaison d'horloges global (T1G) et associé à la première échelle de temps locale (CL1), et la première différence de temps (T1D) reflète la distance temporelle entre le temps de début global (TGO) et le premier temps de début local (TLO), et la première différence de temps (T1D) est ensuite mise à disposition pour une utilisation ultérieure dans le dispositif de vérification (10) et/ou pour une utilisation dans un dispositif de vérification supplémentaire.

2. Procédé selon la revendication 1, **caractérisé en ce que** la première différence de temps (T1D) déterminée à l'étape de procédé B et/ou le premier signal d'horloge (Tc1) est ou sont transmis à la première unité de calcul (Cn1) et/ou à la première unité d'entrée-sortie (171).

3. Procédé selon la revendication 1 ou la revendication 2, **caractérisé en ce que** l'étape de procédé B est déclenchée au moyen d'un deuxième signal de commutation (Tr2) émis par une deuxième unité d'émission (316) de signaux de commutation.

4. Procédé selon la revendication 3, **caractérisé en ce que** le deuxième signal de commutation (Tr2), à un instant prédéfini, stocké dans l'unité de convertisseur (300) de signaux temporels et, dans le temps,
- d'une part, postérieur au premier instant de commutation (Tx1) et,
- d'autre part, postérieur à l'expiration d'un premier intervalle de temps d'établissement (Tosc) de la première PLL (191),
est envoyée à la première horloge (166) et/ou à la première unité de calcul (Cn1).

5. Procédé selon l'une quelconque des revendications 1 à 4, **caractérisé en ce que** le dispositif de vérification (10) est connecté à un autre dispositif de vérification via des moyens de connexion de données, et l'autre dispositif de vérification est un équivalent similaire du dispositif de vérification.

6. Procédé selon l'une quelconque des revendications 1 à 5, **caractérisé en ce que** la première différence de temps (T1D) entre dans les calculs de la première unité de calcul (Cn1) convertir un instant quelconque postérieur au premier instant de comparaison d'horloges global
(a) sur l'échelle de temps globale (CG1) en un instant connexe de la première échelle de temps locale (CL1), ou
(b) sur l'échelle de temps locale (CL1) en un instant connexe de l'échelle de temps globale (CG1).

7. Dispositif de vérification (10) pour tester au moins un premier appareil de régulation, dans lequel le dispositif de vérification (10) comprend au moins : une première unité de calcul (Cn1) pour l'exécution d'un code de modèle, dans lequel un signal simulé de système commandé peut être mis à disposition au moyen du code de modèle pour la stimulation de l'appareil de régulation et un signal d'actionneur de l'appareil de régulation peut être traité, et une première unité de convertisseur (300) de signaux temporels présentant au moins
(i) une première interface (G1) de signaux temporels pour recevoir un premier signal temporel (Ts1) d'une source de signaux temporels globale qui est associée à une échelle de temps globale,
et
(ii) une première unité d'émission (310) de signaux de commutation qui est configurée pour fournir un premier signal de commutation (Tr1) destiné à être transmis à un premier multiplexeur (164),
et
(iii) une première unité d'émission d'horloge (312) qui est configurée pour générer un premier signal de commande temporelle périodique (Tp1) à partir du premier signal temporel (Ts1) et pour délivrer le premier signal de commande temporelle périodique (Tp1) à une première PLL (191), et dans lequel le dispositif de vérification (10) comprend en outre :
(a) un premier oscillateur (161) qui est configuré pour générer un deuxième signal de commande temporelle périodique (Tp2) et pour délivrer le deuxième signal de commande temporelle périodique (Tp2) à une deuxième PLL (192), et
(b) une première horloge (166) qui, d'une part, est reliée au premier multiplexeur (164) au moyen d'une première ligne (168) de signal de commande temporelle et, d'autre part, est configurée pour transmettre un premier signal d'horloge (Tc1) relatif à une première échelle de temps locale (CL1) à une première unité d'entrée-sortie (171) et/ou à la première unité de calcul (Cn1),
dans lequel une première entrée de multiplexeur du premier multiplexeur (164) est connectée à une première sortie PLL de la première PLL (191) pour transmettre un premier signal de commande temporelle stabilisé en fréquence (Tp11) dans la direction du premier multiplexeur (164), et dans lequel une deuxième entrée de multiplexeur du premier multiplexeur (164) est connectée à une deuxième sortie PLL de la deuxième PLL (192) pour transmettre un deuxième signal de commande temporelle stabilisé en fréquence (Tp22) vers le premier multiplexeur (164), et dans lequel le premier signal de commutation (Tr1) est prévu pour, avec lui, commander le premier multiplexeur (164) de sorte qu'en fonction d'un état du signal de commutation (Tr1), soit le premier signal de commande temporelle stabilisé en fréquence (Tp11) soit le deuxième signal de commande temporelle stabilisé en fréquence (Tp22) peut être transmis à la première horloge (166) au moyen du premier multiplexeur (164), et dans lequel la première horloge (166) est configurée pour, en fonction de l'état du signal de commutation (Tr1), traiter soit le premier signal de commande temporelle stabilisé en fréquence (Tp11), soit le deuxième signal de commande temporelle stabilisé en fréquence (Tp22) afin de générer le premier signal d'horloge (Tc1),
dans lequel la première unité d'émission (310) de signaux de commutation est configurée pour, au moyen d'une unité d'émission (314) de message temporel, en cas d'existence d'un premier instant de commutation (Tx1) prédéfini et fixé par une unité d'émission (314) de message temporel, effectuer un changement d'état du premier signal de commutation (Tr1), et
dans lequel le dispositif de vérification (10) est en outre configuré pour,
- dans une étape de procédé A, à la suite du changement d'état du premier signal de commutation (Tr1), déclencher qu'une retransmission du deuxième signal de commande temporelle stabilisé en fréquence (Tp22) via la première ligne (168) de signal de commande temporelle vers la première horloge (166) est interrompue au premier instant de commutation (Tx1) au moyen du premier multiplexeur (164), et qu'une retransmission du premier signal de commande temporelle stabilisé en fréquence (Tp11) via la première ligne (168) de signal de commande temporelle vers la première horloge (166) est provoquée au premier instant de commutation (Tx1),
et
dans lequel le dispositif de vérification (10) est en outre configuré pour,
- dans une étape de procédé B postérieure à l'étape A, déterminer une première différence de temps (T1D) de sorte que
soit sélectionné comme diminuende un premier instant de comparaison d'horloges global (T1G) prédéfini qui est postérieur au premier instant de commutation (Tx1) sur l'échelle de temps globale (CG1), et
soit sélectionné comme diminuteur un premier instant de comparaison d'horloges local (T1L) existant en même temps que le premier instant de comparaison d'horloges global (T1G) et associé à la première échelle de temps locale (CL1),
et la première différence de temps (T1D) résultant de la diminuende et du diminuteur reflète la distance temporelle entre le temps de début global (TGO) et le premier temps de début local (TLO), et la première différence de temps (T1D) est ensuite mise à disposition pour une utilisation ultérieure dans le dispositif de vérification (10) et/ou pour une utilisation dans un dispositif de vérification supplémentaire.

8. Dispositif de vérification (10) selon la revendication 7, **caractérisé par** une aptitude à mettre en œuvre un procédé selon l'une quelconque des revendications 2 à 6.

9. Dispositif de vérification (10) selon la revendication 7 ou 8, **caractérisé en ce que** la première unité de calcul (Cn1) et/ou la première unité d'entrée-sortie (171) est/sont configurée(s) pour associer le premier signal d'horloge (Tc1) à des données calculées de la première unité de calcul (Cn1) et/ou à des données qui ont été reçues via les interfaces d'entrée-sortie (173) de la première unité d'entrée-sortie (171).

10. Système composite comprenant au moins un dispositif de vérification (10) selon l'une quelconque des revendications 7 à 9 et un autre dispositif de vérification configuré de manière à agir de la même manière qu'un dispositif de vérification (10) selon l'une quelconque des revendications 7 à 9, dans lequel le dispositif de vérification (10) et l'autre dispositif de vérification sont reliés via un moyen de transmission de données, et le dispositif de vérification (10) et l'autre dispositif de vérification sont configurés via des moyens de transmission de données
- pour la transmission de données calculées au moyen de la première unité de calcul (Cn1), et/ou
- pour la transmission de données de mesure saisies au moyen d'interfaces d'entrée/sortie (173), et/ou
- pour la transmission de la première différence de temps (T1D) du premier dispositif de vérification à l'autre dispositif de vérification.
